# EUROPEAN PATENT APPLICATION

(11) **EP 2 458 736 A1**
(43) Date of publication of application: **30.05.2012**
(21) Application number: 10802307.8
(22) Date of filing: 22.07.2010
(51) Int. Cl.: H03K 17/08, H02M 1/08, H02M 7/48, H03K 17/695

(54) **SEMICONDUCTOR ELEMENT CONTROLLER AND IN-VEHICLE ELECTRIC SYSTEM**

(30) Priority: 23.07.2009 JP 2009172103
(71) Applicant: Hitachi Automotive Systems, Ltd., Hitachinaka-shi Ibaraki 312-8503 (JP)
(72) Inventor: INABA, Masamitsu, Hitachi-shi Ibaraki 319-1292 (JP); SAKURAI, Naoki, Hitachi-shi Ibaraki 319-1292 (JP)
(74) Representative: MERH-IP Matias Erny Reichl Hoffmann
(86) International application number: PCT/JP2010/062324
(87) International publication number: WO 2011/010687

(57) **Abstract**

A semiconductor element control device that controls a semiconductor element that performs switching operation for converting DC power into AC power, or AC power into DC power, includes: a drive unit that outputs a drive signal for controlling the switching operation of the semiconductor element to a terminal of the semiconductor element; a short-circuit detection unit that detects short-circuit of the semiconductor element on the basis of the voltage at the terminal, and outputs a short-circuit detection signal; and a drive interruption unit that interrupts current flowing in the semiconductor element on the basis of the short-circuit detection signal output from the short-circuit detection unit.

## Description

### TECHNICAL FIELD

The present invention relates to a semiconductor element control device controlling semiconductor elements which perform switching operations to convert direct-current (DC) power to alternating-current (AC) power or AC power to DC power, and relates to an electrical machine system to be mounted on a vehicle having the semiconductor element control device.

### Background Art

A power inverter includes a function to convert DC power supplied from a DC power supply into AC power to be supplied to AC electrical load such as a rotating electrical machine or a function to convert AC power generated by a rotating electrical machine into DC power to be supplied to a DC power supply. To serve such conversion function, the power inverter includes an inverter circuit having plurality of switching elements. The switching elements repeat conduction operations and interruption operations so that power is converted from DC power to AC power or from AC power to DC power.

With a circuit that drives the switching elements described above, if there is no circuit for protection during an abnormality such as a power supply short circuit or the like, then there is a fear that excessively great current may flow in the switching elements, and that the circuit may be destroyed by heat generated in the elements or by a switching surge voltage, and this would be undesirable. A technology for suppressing overcurrent during this kind of short-circuit is described in Patent Document #1. According to Patent Document #1, it is described to detect overcurrent and short-circuit and to switch the IGBT to interrupting, on the basis of sense current for the IGBT,

### PRIOR ART DOCUMENTS

### PATENT LITERATURE

Patent Document #1: Japanese Laid-Open Patent Publication Heisei 3-40517.

### SUMMARY OF THE INVENTION

### PROBLEMS TO BE SOLVED BY THE INVENTION

With a prior art power conversion device that detects overcurrent and short-circuit on the basis of sense currents as described in Patent Document #1 mentioned above, erroneous detection of overcurrent or short-circuit can easily occur if switching noise is present upon the sense currents due to the switching operation of the IGBT. It is desirable to reduce this type of erroneous detection as much as possible.

### MEANS FOR SOLVING THE PROBLEMS

According to the first aspect of the present invention, a semiconductor element control device that controls a semiconductor element that performs switching operation for converting DC power into AC power, or AC power into DC power, comprises: a drive unit that outputs a drive signal for controlling the switching operation of the semiconductor element to a terminal of the semiconductor element; a short-circuit detection unit that detects short-circuit of the semiconductor element on the basis of the voltage at the terminal, and outputs a short-circuit detection signal; and a drive interruption unit that interrupts current flowing in the semiconductor element on the basis of the short-circuit detection signal output from the short-circuit detection unit.
According to the second aspect of the present invention, in the semiconductor element control device of the first aspect, it is preferred that the semiconductor element control device further comprises an overcurrent detection unit that detects overcurrent flowing in the semiconductor element on the basis of a sense current output by the semiconductor element, and outputs an overcurrent detection signal; and a filter unit that eliminates a noise component in the overcurrent detection signal output from the overcurrent detection unit; wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.
According to the third aspect of the present invention, a semiconductor element control device that controls a semiconductor element that performs switching operation for converting DC power into AC power, comprises: a drive unit that outputs a drive signal for controlling the switching operation of the semiconductor element to a terminal of the semiconductor element; a short-circuit detection unit that detects short-circuit of the semiconductor element on the basis of the voltage at the terminal and a sense current output by the semiconductor element, and outputs a short-circuit detection signal; and a drive interruption unit that interrupts current flowing in the semiconductor element on the basis of the short-circuit detection signal output from the short-circuit detection unit.
According to the fourth aspect of the present invention, in the semiconductor element control device of the third aspect, it is preferred that the semiconductor element control device further comprises an overcurrent detection unit that detects overcurrent in the semiconductor element on the basis of the voltage at the terminal and the sense current, and outputs an overcurrent detection signal; and a filter unit that eliminates a noise component in the overcurrent detection signal output from the overcurrent detection unit; wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.
According to the fifth aspect of the present invention, in the semiconductor element control device of the fourth aspect, it is preferred that the overcurrent detection unit detects overcurrent in the semiconductor element and outputs the overcurrent detection signal, when the voltage at the terminal exceeds a predetermined first voltage value, and also the sense current exceeds a predetermined first current value; and the short-circuit detection unit detects short-circuit of the semiconductor element and outputs the short-circuit detection signal, when the voltage at the terminal exceeds a predetermined second voltage value that is higher than or equal to the first voltage value, and also the sense current exceeds a predetermined second current value that is less than or equal to the first current value.
According to the sixth aspect of the present invention, an in-vehicle electrical system, comprising: an in-vehicle power supply that can be charged and discharged; a motor-generator that generates mechanical power on the basis of AC electrical power, and AC power on the basis of mechanical power; and a power conversion device that, along with converting DC power from the in-vehicle power supply to AC power that it supplies to the motor-generator, also converts AC power generated by the motor-generator to DC power with which it charges up the in-vehicle power supply; wherein the power conversion device comprises: a plurality of semiconductor elements that perform switching operation for converting DC power from the in-vehicle power supply into AC power, or AC power generated by the motor-generator into DC power; a drive unit that outputs drive signals for controlling the switching operation of the semiconductor element to terminals of the semiconductor element; a short-circuit detection unit that detects short-circuit of the semiconductor element on the basis of the voltage at the terminal, and outputs a short-circuit detection signal; and a drive interruption unit that interrupts current flowing in the semiconductor element on the basis of the short-circuit detection signal output from the short-circuit detection unit.
According to the seventh aspect of the present invention, in the in-vehicle electrical system of the sixth aspect, it is preferred that the in-vehicle electrical system further comprises an overcurrent detection unit that detects overcurrent flowing in the semiconductor element on the basis of sense current output by the semiconductor element, and outputs an overcurrent detection signal; and a filter unit that eliminates a noise component in the overcurrent detection signal output from the overcurrent detection unit; wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.
According to the eighth aspect of the present invention, an in-vehicle electrical system, comprises: an in-vehicle power supply that can perform charging and discharging; a motor-generator that generates mechanical power on the basis of AC electrical power, and AC power on the basis of mechanical power; and a power conversion device that, along with converting DC power from the in-vehicle power supply to AC power that it supplies to the motor-generator, also converts AC power generated by the motor-generator to DC power with which it charges up the in-vehicle power supply; wherein the power conversion device comprises: a plurality of semiconductor elements that perform switching operation for converting DC power from the in-vehicle power supply into AC power, or AC power generated by the motor-generator into DC power; a drive unit that outputs drive signals for controlling the switching operation of the semiconductor element to terminals of the semiconductor element; a short-circuit detection unit that detects short-circuit of the semiconductor element on the basis of the voltage at the terminal and sense current output by the semiconductor element, and outputs a short-circuit detection signal; and a drive interruption unit that interrupts current flowing in the semiconductor element on the basis of the short-circuit detection signal output from the short-circuit detection unit.
According to the ninth aspect of the present invention, in the in-vehicle electrical system of the eighth aspect, it is preferred that the in-vehicle electrical system further comprises an overcurrent detection unit that detects overcurrent flowing in the semiconductor element on the basis of the voltages at the terminals and the sense current, and outputs an overcurrent detection signal; and a filter unit that eliminates a noise component in the overcurrent detection signal output from the overcurrent detection unit; wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.
According to the tenth aspect of the present invention, in the in-vehicle electrical system of the ninth aspect, it is preferred that the overcurrent detection unit detects overcurrent flowing in the semiconductor element and outputs the overcurrent detection signal, when the voltage at the terminal exceeds a predetermined first voltage value, and also the sense current exceeds a predetermined first current value; and the short circuit detection unit detects short-circuit of the semiconductor element and outputs the short-circuit detection signal, when the voltage at the terminal exceeds a predetermined second voltage value that is less than or equal to the first voltage value, and also the sense current exceeds a predetermined second current value that is less than or equal to the first current value.

### ADVANTAGEOUS EFFECT OF THE INVENTION

According to the present invention, it is possible to implement short circuiting protection with high reliability and with no erroneous detection of excessive current flow or short circuiting taking place, even if switching noise is present upon the sense currents or the like.

### BRIEF DESCRIPTION OF THE DRAWINGS

Fig. 1 is a figure showing control blocks of a hybrid automobile;
Fig. 2 is a figure showing the circuit structure of an electrical system for vehicle propulsion that includes an inverter device including upper and lower arm series circuits and a control unit, a power conversion device that consists of a capacitor connected to the DC side of the inverter device, a battery, and a motor-generator;
Fig. 3 is a circuit block diagram of a semiconductor element control device according to a first embodiment of the present invention;
Fig. 4 is a circuit diagram of the semiconductor element control device according to the first embodiment of the present invention;
Fig. 5 is a time chart during the operation of the semiconductor element control device according to the first embodiment of the present invention;
Fig. 6 is a circuit block diagram of a semiconductor element controller according to a second embodiment of the present invention;
Fig. 7 is a circuit diagram of the semiconductor element control device according to the second embodiment of the present invention;
Fig. 8 is a time chart during the operation of the semiconductor element control device according to the second embodiment of the present invention;
Fig. 9 is a circuit block diagram of a semiconductor element control device according to a variant embodiment of the second embodiment of the present invention;
Fig. 10 is a circuit block diagram of a semiconductor element control device according to another variant embodiment of the second embodiment of the present invention; and
Fig. 11 is a general figure showing an example of an arrangement of a sense resistor.

### EMBODIMENTS FOR IMPLEMENTATION OF THE INVENTION

### - First Embodiment -

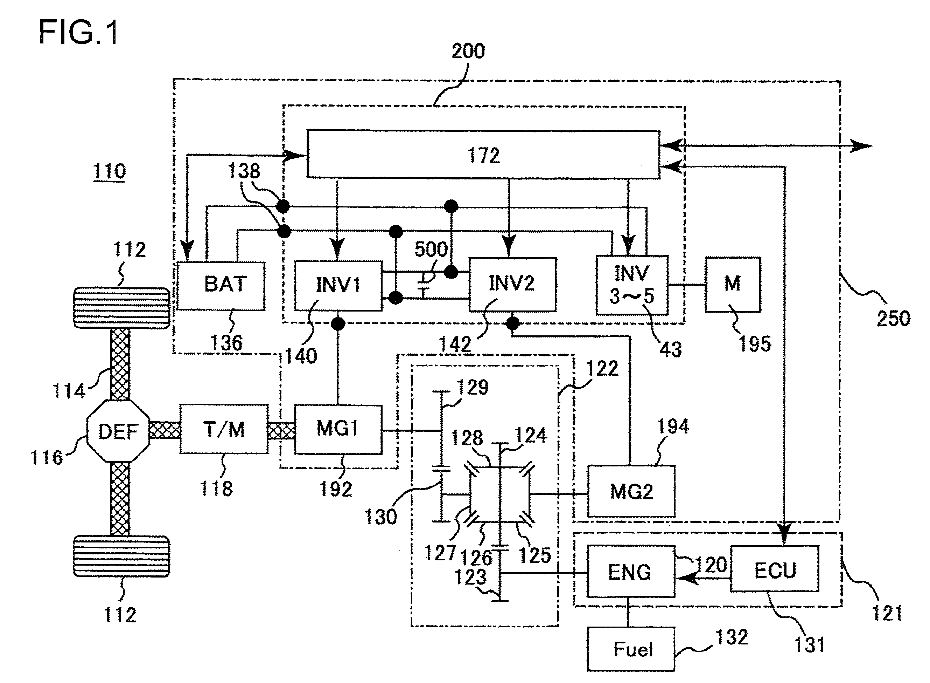

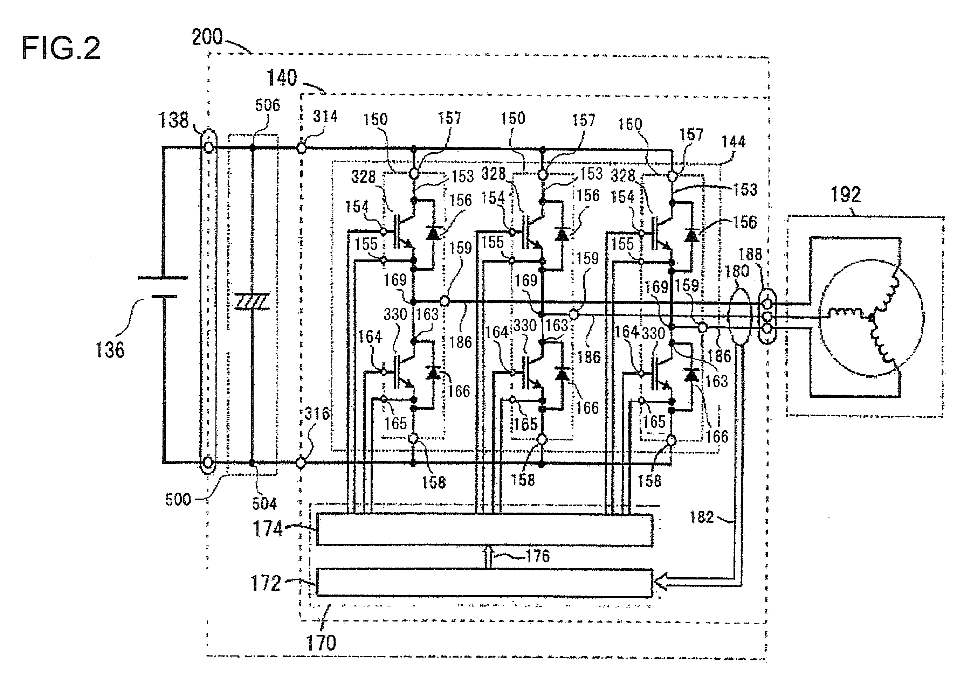

In the embodiment hereinafter described, the semiconductor element control device and an electrical machine system to be mounted on a vehicle with reference to the drawings. The semiconductor element control device according to an embodiment of the present invention is equipped in a power inverter which converts from DC power to AC power or from AC power to DC power and controls semiconductor elements which perform switching operations to perform such conversion of an electric power. A power inverter having a semiconductor element control device in accordance with the embodiment of the present invention is applicable to hybrid vehicles and ordinary electric vehicles. The control configuration and the circuit configuration of the power inverter to which the power inverter in accordance with the embodiment of the present invention is applied will be described with reference to the Figs. 1 and 2. Fig. 1 shows a control block diagram for a hybrid vehicle. Fig. 2 is a circuit diagram that shows an electric system for driving a vehicle that includes the power inverter, a battery and a motor generator. The power inverter includes an inverter unit provided with series circuits of upper and lower arms and a control unit, and a capacitor module that is connected to DC side of the inverter unit.

The power inverter in accordance with the present embodiment will be described with an example of an in-vehicle power inverter of in-vehicle electric system to be mounted on a vehicle, particularly an inverter device for driving a vehicle that is used for an electric system for driving a vehicle in a challenging environment in terms of installation and operation. The inverter device for driving a vehicle is mounted on the electric system for driving a vehicle as a control device for controlling drive of electric machine for driving a vehicle, converts DC electric power which is supplied from an in-vehicle battery or power generating equipment into AC electric power, supplies the obtained AC electric power to the electric machine for driving a vehicle, and thus controls drive of the electric machine for driving a vehicle. Since the electric machine for driving a vehicle includes function as a generator, the inverter device for driving a vehicle converts AC electric power generated by the electric machine for driving a vehicle into DC electric power depending on operation mode. The converted DC electric power is supplied to the in-vehicle battery.

The configuration of the present embodiment is most appropriate for power inverters for driving vehicles such as automobiles and trucks. However, it is also applicable to other power inverters including power inverters for trains, ships, and airplanes, industrial power inverters used as a control device for electric machine which drives plant, or household power inverters used as a control device for electric machine which drives household solar power system or consumer electronics.

In Fig. 1, a hybrid electric vehicle (HEV) 110 is an electric vehicle provided with two systems for a driving vehicle. One of the systems is an engine system powered by an internal combustion engine 120. The engine system is mainly used as a drive source for HEV. The other system is an in-vehicle electric system powered by motor generators 192 and 194. The in-vehicle electric system is mainly used as a drive source or a power generation source for HEV. Each of the motor generators 192 and 194 is, for example, a synchronous machine or an induction machine, which is operated either as a motor or as a generator depending on operation mode.

A front axle 114 is rotatably supported in a front part of the vehicle body. A pair of front wheels 112 are provided on both ends of the front axle 114. A rear axle (not herein figured) is rotatably supported in a rear part of the vehicle body. A pair of rear wheels (not herein figured) are provided on both ends of the rear axle. Even though a front-wheel drive system, in which main wheels powered by the engine are set to the front wheels 112 while driven wheels subordinated are set to the rear wheels, is applied to the HEV in the present embodiment, a rear-wheel drive system may be applied.

A front differential gear (Front DEF) 116 is provided in the center of the front axle 114. The front axle 114 is mechanically connected to an output side of the front DEF 116. An input side of the front DEF 116 is mechanically connected to an output shaft of a transmission 118. The front DEF 116 is a differential power transfer mechanism that distributes a rotational driving force with its speed reduced and transferred by the transmission 118 to the front axle 114 in right and left. Input of the transmission 118 is mechanically connected to output of the motor generator 192. An input side of the motor generator 192 is mechanically connected to an output side of the engine 120 and output of the motor generator 194 via a power transfer mechanism 122. The motor generators 192 and 194 and the power transfer mechanism 122 are contained in a chassis of the transmission 118.

The power transfer mechanism 122 is a differential mechanism made up of gears 123 to 130. The gears 125 to 128 are bevel gears. The gears 123, 124, 129, and 130 are spur gears. Power by the motor generator 192 is directly transferred to the transmission 118. An axis of the motor generator 192 is coaxial with the gear 129. This configuration makes the power transferred to the gear 129 directly transferred to the input side of the transmission 118, in the case when no electric power is supplied to the motor generator 192.

When the gear 123 is driven by the engine 120, the power of the engine 120 is transferred from the gear 123 to the gear 124, from the gear 124 to the both of the gears 126 and 128, from the both of the gears 126 and 128 to the gear 130, and lastly transferred to the gear 129. When the gear 125 is driven by the motor generator 194, rotation of the motor generator 194 is transferred from the gear 125 to the both of the gears 126 and 128, from the both of the gears 126 and 128 to the gear 130, and lastly transferred to the gear 129. For the power transfer mechanism 122, other mechanisms including a planetary gear mechanism may be applied in place of the differential mechanism described above.

Each of the motor generators 192 and 194 is the synchronous machine with permanent magnets in its rotor. Drive of the motor generators 192 and 194 is controlled by inverter devices 140 and 142 that control AC electric power supplied to armature coils of a stator of the motor generators 192 and 194. Since the inverter devices 140 and 142 are electrically connected to a battery 136, electric power is transferable between the battery 136 and each of the inverter devices 140 and 142.

In the present embodiment, a first motor-generator unit made up of the motor generator 192 and the inverter device 140 and a second motor-generator unit made up of the motor generator 194 and the inverter device 142 are provided and selectively used depending on the state of operation. In other words, in the case of assisting drive torque when the vehicle is driven by the power of the engine 120, the second motor-generator unit is operated as a generating unit by the power of the engine 120 for generating electric power, and the first motor-generator unit is operated as a motor unit by the electric power generated by the second motor-generator unit. In the case of assisting vehicle speed when the vehicle is driven by the power of the engine 120, the first motor-generator unit is operated as a generating unit by the power of the engine 120 for generating electric power, and the second motor-generator unit is operated as a motor unit by the electric power generated by the first motor-generator unit.

In the present embodiment, operating the first motor-generator unit as a motor unit by the electric power of the battery 136 enables the vehicle to be driven only by the power of the motor generator 192. In the present embodiment, the battery 136 is recharged by operating either the first motor-generator unit or the second motor-generator unit as a generating unit by either the power of the engine 120 or wheels.

The battery 136 is used as a battery for driving a motor 195 for auxiliaries. The auxiliaries include, for example, a motor for driving an air-conditioning compressor and a motor for driving a control hydraulic pump. DC electric power is supplied from the battery 136 to an inverter device 43, converted into AC electric power by the inverter device 43, and supplied to the motor 195. The inverter device 43 is provided with a similar function to that of the inverter devices 140 and 142, and controls phase, frequency and electric power of AC supplied to the motor 195. The motor 195 generates torque, for example, by supplying AC electric power of leading phase to rotation of a rotor of the motor 195. On the other hand, the motor 195 acts as an electric generator and operates regenerative braking, by generating AC electric power of lagging phase. The control function of the inverter device 43 is similar to that of the inverter device 140 or 142. Since capacity of the motor 195 is smaller than that of the motor generator 192 or 194, maximum conversion electric power of the inverter device 43 is smaller than that of the inverter device 140 or 142. Circuit configuration of the inverter device 43, however, is basically the same as that of the inverter device 140 or 142.

The inverter devices 140, 142, and 43, and a capacitor module 500 are in an electrically close relation between themselves, and commonly require measures against the heat and miniaturization of the devices. The power inverter detailed below thus contains the inverter devices 140, 142, and 43, and the capacitor module 500 in its chassis. This configuration realizes a small and reliable device.

Containing the inverter devices 140, 142, and 43, and the capacitor module 500 in the single chassis have advantageous effects in simplification of wiring and noise filtering. Inductance of the connection circuits between the capacitor module 500 and each of the inverter devices 140, 142, and 43 can also be reduced. Spike voltage and the heat are also reduced. Heat generation is reduced and radiation efficiency is thus improved.

Electric circuit configurations of the inverter devices 140, 142, and 43 will be described below with reference to Fig. 2. The inverter devices 140, 142, and 43 have similar configurations, advantageous effects, and functions in common. In the following explanation, therefore, the inverter device 140 will be described as a representative example.

A power inverter 200 in accordance with the present embodiment is provided with the inverter device 140 and the capacitor module 500. The inverter device 140 is provided with an inverter circuit 144 and a control unit 170. The inverter circuit 144 is provided with a plurality of upper and lower arms series circuits 150 including an IGBT (insulated gate bipolar transistor) 328 and a diode 156 which operate as the upper arm and an IGBT 330 and a diode 166 which operate as the lower arm. Three of the upper and lower arms series circuits 150, 150, and 150 are illustrated in Fig. 2. The inverter circuit 144 is connected to the motor generator 192 at midpoints of the upper and lower arms series circuits 150 (intermediate electrodes 169), which are connected to AC electric power lines (AC busbars) 186 of the motor generator 192 via AC terminals 159. The control unit 170 includes a gate drive circuit 174 which drives and controls the inverter circuit 144, and a control circuit 172 which supplies control signal to the gate drive circuit 174 through a signal line 176.

The IGBTs 328 and 330 of the upper and lower arms are switching power semiconductor devices which are operated in response to drive signals output from the control unit 170 and convert DC electric power supplied from the battery 136 into three-phase AC electric power. The converted electric power is supplied to the armature coil of the motor generator 192. As described above, the inverter device 140 converts three-phase AC electric power generated by the motor generator 192 into DC electric power.

As shown in Fig. 1, the power inverter 200 in accordance with the present embodiment is provided with the inverter devices 140, 142, and 43, and the capacitor module 500. As described above, since the inverter devices 140, 142, and 43 have circuit configurations in common, the inverter device 140 is mentioned as a representative example and the others are not mentioned.

The inverter circuit 144 is made up of a three-phase bridge circuit wherein the upper and lower arms series circuits 150, 150, and 150 for three phases are electrically connected in parallel between a DC positive terminal 314 and a DC negative terminal 316 that are electrically connected to the positive and negative terminals of the battery 136 respectively. The upper and lower arms series circuit 150 is called an arm and provided with the upper arm switching power semiconductor device 328, the diode 156, the lower arm switching power semiconductor device 330, and the diode 166.

In the present embodiment, the switching power semiconductor devices are illustrated by an example of the IGBTs 328 and 330. The IGBTs 328 and 330 are provided with collectors 153 and 163, emitters (signal emitter terminals 155 and 165), and gate electrodes (gate electrode terminals 154 and 164). As Figured, the diodes 156 and 166 are electrically connected between each of the collectors 153 and 163 and the emitters of the IGBTs 328 and 330, respectively. The diodes 156 and 166 are provided with two electrodes, i.e., cathode and anode electrodes. The cathode and anode electrodes are electrically connected to the collectors and emitters of the IGBTs 328 and 330 respectively so that the direction from the emitters to the collectors of the IGBTs 328 and 330 is forward direction. A MOSFET (metal-oxide semiconductor field-effect transistor) may be employed for the switching power semiconductor device which makes the diodes 156 and 166 unnecessary.

The upper and lower arms series circuits 150 are provided for three phases corresponding to each phase coil of the armature coil of the motor generator 192. Each of the three upper and lower arms series circuits 150 makes up either one of the U-phase, V-phase, or W-phase for the motor generator 192 through the intermediate electrodes 169 which connect the emitters of the IGBTs 328 with the collectors 163 of the IGBT 330 and the AC terminals 159. The upper and lower arms series circuits 150 are electrically connected in parallel between each other. The collectors 153 of the IGBTs 328 of the upper arm and the emitters of the IGBTs 330 of the lower arm are electrically connected by DC busbar to a positive electrode of the capacitor module 500 via the positive electrode terminal (P terminal) 157 and to a negative electrode of the capacitor module 500 via the negative electrode terminal (N terminal) 158, respectively. The intermediate electrodes 169, that is, the midpoints of each of the arms (connection of the emitters of the IGBTs 328 of the upper arm and the collectors of the IGBTs 330 of the lower arm), are electrically connected to the phase coil which corresponds to the armature coil of the motor generator 192 through an AC connector 188.

The capacitor module 500 constitutes a smoothing circuit which reduces fluctuation in DC voltage generated by switching operation of the IGBTs 328 and 330. The positive electrode and the negative electrode of the capacitor module 500 are electrically connected to positive and negative sides of the battery 136 through a DC connector 138 respectively. The capacitor module 500 is thus electrically connected in parallel to the battery 136 and the upper and lower arms series circuits 150 at both between the collectors 153 of the upper arm IGBTs 328 and the positive terminal side of the battery 136 and between the emitters of the lower arm IGBTs 330 and the negative terminal side of the battery 136.

The control unit 170 is designed to operate the IGBTs 328 and 330 and includes the control circuit 172 which generates a timing signal for controlling switching timing of the IGBTs 328 and 330 in accordance with information input from other control devices or sensors, and a drive circuit 174, which generates a drive signal for switching operation of the IGBTs 328 and 330 in accordance with the timing signal output from the control circuit 172.

The control circuit 172 is provided with a microcomputer for computational processing of the switching timing of the IGBTs 328 and 330. The microcomputer is provided with input information including a target torque required for the motor generator 192, a current value supplied from the upper and lower arms series circuits 150 to the armature coil of the motor generator 192, and a magnetic pole position of the rotor of the motor generator 192. The target torque is set in accordance with a command signal output from a superordinate control device not figured herein. The current value is detected in accordance with a detection signal output from a current sensor 180. The magnetic pole position is detected based on a detection signal output from a rotating magnetic pole sensor (not Figured herein) provided in the motor generator 192. In the present embodiment, description will be given with an example of detection of three-phase current value. Two-phase current value, however, may instead be detected.

The microcomputer in the control circuit 172 calculates a current command value of d- and q-axis of the motor generator 192 in accordance with the target torque, calculates a voltage command value of the d- and q-axis in accordance with the difference between the calculated current command value of the d- and q-axis and a detected current value of the d- and q-axis, and converts the calculated voltage command value of the d- and q-axis into a voltage command value for U-phase, V-phase, and W-phase in accordance with the detected magnetic pole position. The microcomputer generates a pulse modulated wave according to comparison of a fundamental wave (sine wave) based on the voltage command value for U-phase, V-phase, and W-phase with a carrier wave (triangle wave), and outputs the generated modulated wave to the gate drive circuit 174 as a pulse-width modulation (PWM) signal.

When the lower arm is driven, the gate drive circuit 174 amplifies and outputs the PWM signal as a drive signal to the gate electrodes of the IGBTs 330 of the corresponding lower arm. When the upper arm is driven, the gate drive circuit 174 shifts from a reference potential level of the PWM signal to a reference potential level of the upper arm, amplifies and outputs the amplified PWM signal as a drive signal to the gate electrodes of the IGBTs 328 of the corresponding upper arm. Each of the IGBTs 328 and 330 performs switching operation in response to the input drive signals.

The gate drive circuit 174 detects abnormality (short-circuit, overcurrent, overvoltage, over temperature, etc.) for protecting the upper and lower arms series circuits 150. Consequently, sensing information is input to the gate drive circuit 174. For example, information of gate voltage on each of the IGBTs 328 and 330 is input to a drive unit (IC) of the corresponding drive circuit 174. Each input to a drive unit (IC) detects short-circuit, stops switching operation of the corresponding IGBTs 328 and 330 in the case short-circuit is detected, and protects the corresponding IGBTs 328 and 330 from short-circuit. Information of collector current which flows through each of the IGBTs 328 and 330 is input to a drive unit (IC) of the corresponding drive circuit 174. Each drive unit (IC) thus detects overcurrent, stops switching operation of the corresponding IGBTs 328 and 330 in the case overcurrent is detected, and protects the corresponding IGBTs 328 and 330 from overcurrent. These protection operations during short-circuit and overcurrent will be explained precisely later.

Temperature information of the upper and lower arms series circuits 150 is input from a temperature sensor (not figured herein) provided to a drive unit (IC) of the corresponding drive circuit 174. Voltage information of positive side of DC of the upper and lower arms series circuits 150 is input to the corresponding drive circuit 174. Each drive unit (IC) detects over temperature and overvoltage based on those information, stops all switching operations of the IGBTs 328 and 330 in the case over temperature or overvoltage is detected, and protects the upper and lower arms series circuits 150 and therefore the semiconductor module which includes the circuits 150 from over temperature or overvoltage.

In Fig. 2, the upper and lower arms series circuits 150 are series circuits which include the IGBTs 328 of the upper arm, the diodes 156 of the upper arm, the IGBTs 330 of the lower arm, and the diodes 166 of the lower arm, wherein the IGBTs 328 and 330 are the switching semiconductor devices. Conduction operation and interrupting operation of the IGBTs 328 and 330 of the upper and lower arms of the inverter circuit 144 alternate constantly. Electric current through the stator coil of the motor generator 192 at the alternation flows through a circuit includes the diodes 156 and 166.

As illustrated, the upper and lower arms series circuit 150 is provided with the positive terminal (P terminal) 157, the negative terminal (N terminal) 158, the AC terminals 159 from the intermediate electrode 169 of the upper and lower arms, the signal emitter terminal 155 of the upper arm, the gate electrodes terminal 154 of the upper arm, the signal emitter terminal 165 of the lower arm, and the gate electrodes terminal 164 of the lower arm. The power inverter 200 is provided with the DC connector 138 on its input side and the AC connector 188 on its output side, and is connected to each of the battery 136 and the motor generator 192 via each of the connectors 138 and 188. A power inverter with circuit configuration in which two of the upper and lower arms series circuits are connected in parallel to each phase may be employed for a circuit that generates outputs of each phase of the three-phase AC which is output to the motor generator.

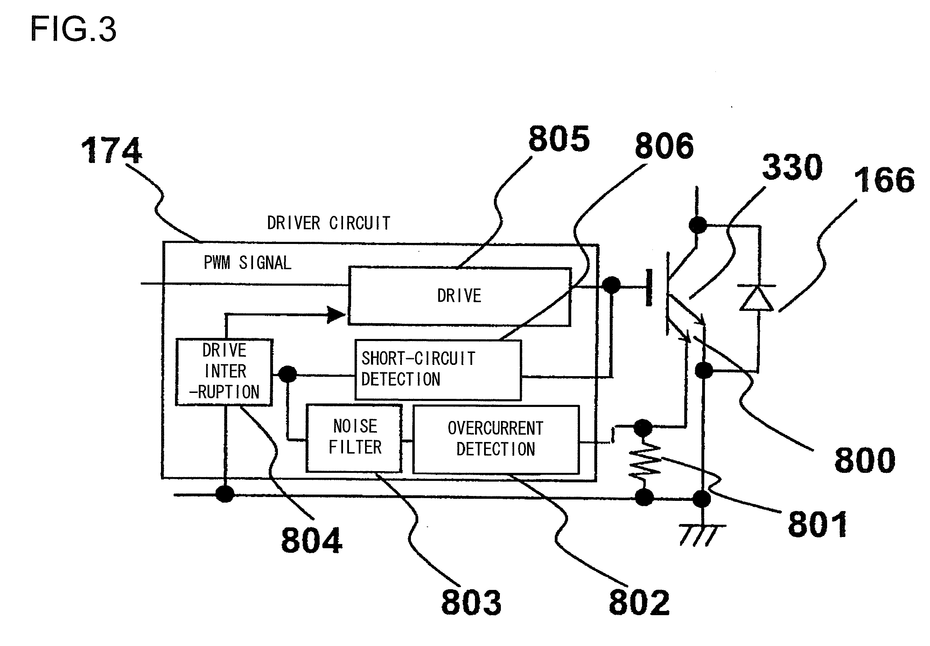

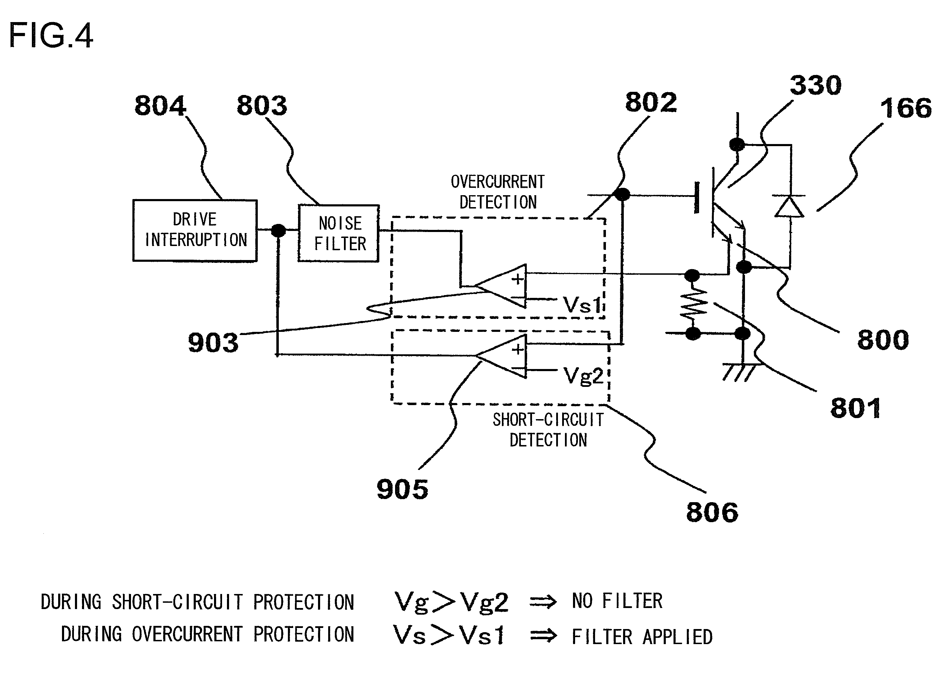

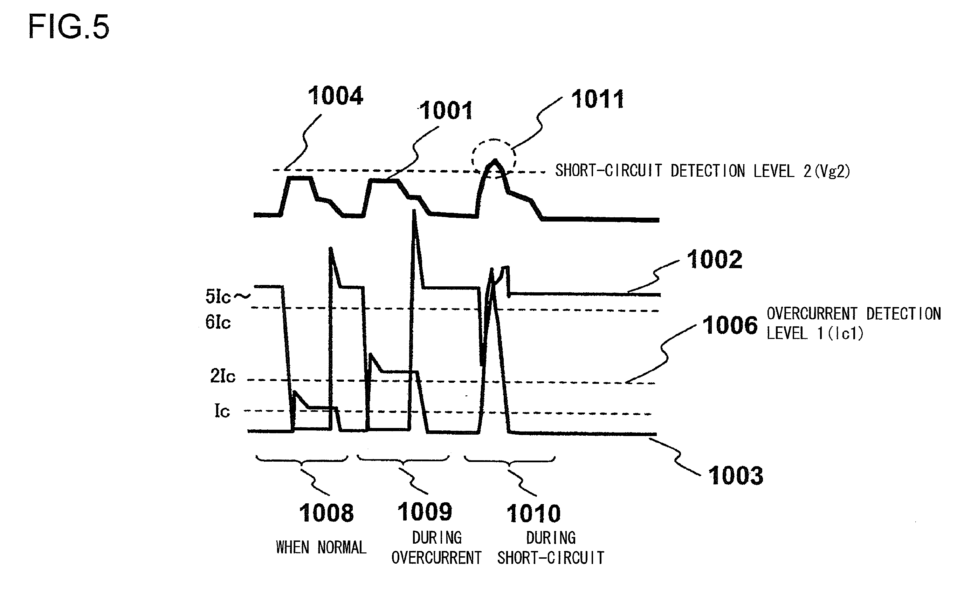

Next, the protection operation during short-circuit and overcurrent will be explained. In this embodiment, as previously described, during short-circuit and overcurrent, protection operation is performed by a semiconductor element control device having various types, including the drive circuit 174. In the following, as an example, the operation of the IGBT 330 and one of the diodes 166 as a lower arm in the inverter circuit 144 of Fig. 2 will be explained. It should be understood that the protective operation during short-circuit and overcurrent for the IGBT 328 and the diodes 156 that operate as the upper arms is the same as in the case of the lower arms. Fig. 3 is a circuit block diagram of a semiconductor element control device related to this embodiment, Fig. 4 is a circuit diagram of this semiconductor element control device related to this embodiment, and Fig. 5 is a time chart for this semiconductor element control device related to this embodiment during operation.

In Fig. 3, the reference symbol 800 denotes a sense IGBT that separates off a part of the current of the IGBT 330 and outputs it as a sense current. A sense resistor 801 is connected to this sense IGBT 800. When the sense current from the sense IGBT 800 flows to the sense resistor 801, a voltage (a sense voltage) corresponding to the magnitude of this sense current is generated across the sense resistor 801. This sense voltage is input to an overcurrent detection unit 802 within the drive circuit 174. The overcurrent detection unit 802 performs detection of overcurrent in the IGBT 330 by comparing together the sense voltage that is input and a reference voltage that is set according to a predetermined overcurrent detection level. If overcurrent has been detected, then the overcurrent detection unit 802 outputs an overcurrent detection signal to a drive interruption unit 804 via a noise filter 803. The noise filter 803 cuts out noise components of a predetermined frequency and higher from the overcurrent detection signal output from the overcurrent detection unit 802.

The gate voltage of the IGBT 330 is input to a short-circuit detection unit 806 within the drive circuit 174. This short-circuit detection unit 806 performs detection of short-circuit of the IGBT 330 by comparing together the gate voltage that is input and a reference voltage that is set according to a predetermined short-circuit detection level. If short-circuit has been detected, then the short-circuit detection unit 806 outputs a short-circuit detection signal to the drive interruption unit 804.

The drive interruption unit 804 determines that the IGBT 330 is in an overcurrent state or is in a short-circuit state when either an overcurrent detection signal from the overcurrent detection unit 802 has passed through the noise filter 803 and has been input, or when a short-circuit detection signal has been input from the short-circuit detection unit 806. And the unit 804 outputs an abnormality interrupting signal to the drive unit 805 for interrupting the current flowing in the IGBT 330. Now, the drive unit 805 outputs a drive signal to the gate terminal of the IGBT 330 for controlling the switching operation of the IGBT 330 on the basis of the PWM signal output from the control circuit 172 of Fig. 2. The switching operation of the IGBT 330 is controlled according to this drive signal. Moreover, when the abnormality interrupting signal is input from the drive interruption unit 804, the switching operation of the IGBT 330 is stopped irrespective of this PWM signal, so that the current flowing in the IGBT 330 is cut off.

The operation of the semiconductor element control device of Fig. 3 will now be explained below. When the drive unit 805 outputs a gate voltage pulse for the IGBT 330, the IGBT 330 is turned ON, and a collector current Ic flows in the IGBT 330. Simultaneously, a portion Is of this collector current Ic flows to the sense IGBT 800, and flows through the sense resistor 801. Due to this, a sense voltage Vs is generated across the sense resistor 801, and this is input to the overcurrent detection unit 802. The overcurrent detection unit 802 has the function of detecting overcurrent and of outputting an overcurrent detection signal, when this sense voltage Vs is greater than a predetermined overcurrent detection level Vs1. This overcurrent detection signal from the overcurrent detection unit 802 passes through the noise filter 803, and is input to the drive interruption unit 804.

Moreover, if the motor is suffering a short to ground or a short to power, then when the IGBT 330 is in turned-on the IGBT 330 goes into the short-circuit state, and a rather large short-circuit current flows in the IGBT 330. At this time the power supply voltage applied between the collector and the emitter of the IGBT 330 momentarily drops, and then this voltage spikes upward. And a current that is generated according to the change of this voltage over time and according to the feedback capacitance of the IGBT 330 flows to the gate of the IGBT 330. Due to this, the phenomenon occurs of the gate voltage spiking up to higher than the power supply voltage (the "spike" phenomenon). The short-circuit detection unit 806 detects short-circuit of the IGBT 330 by employing this spike phenomenon of the gate voltage during short-circuit. For example, a predetermined voltage level that is higher than the gate power supply voltage may be taken as being a short-circuit detection level Vg2. The short-circuit detection unit 806 inputs the gate voltage Vg of the IGBT 330, and, if this gate voltage Vg is greater than the short-circuit detection level Vg2, then it detects that short-circuit has taken place and outputs a short-circuit detection signal. And this short-circuit detection signal from the short-circuit detection unit 806 is input to the drive interruption unit 804.

When the drive interruption unit 804 receives an overcurrent detection signal from the overcurrent detection unit 802 or a short-circuit detection signal from the short-circuit detection unit 806 as described above, then it outputs an abnormality interrupting signal to the drive unit 805. And, apart from the drive unit 805 receiving a PWM signal from the control circuit 172 and outputting a gate drive voltage to turn the IGBT 330 on or off, it also cuts off the IGBT 330 by software when it receives an abnormality interrupting signal from the drive interruption unit 804. The drive unit 805 is also endowed with a function of gate short-circuit, in which it lowers the gate voltage to low impedance with respect to the emitter of the IGBT 330, if the gate voltage becomes a predetermined voltage that is lower than the threshold value of the IGBT 330, for example 3V.

Fig. 4 shows an example of a circuit that implements the functions of the overcurrent detection unit 802 and of the short-circuit detection unit 806 according to this embodiment. The overcurrent detection unit 802 is constituted by a comparator 903 for overcurrent detection. The sense voltage Vs of the sense resistor 801 is input to one input side of the overcurrent detection comparator 903, for example to its non-inverting input side. Furthermore, a reference voltage that is equivalent to the predetermined overcurrent detection level Vs1 is input to its other input side, for example to its inverting input side. The output of the overcurrent detection comparator 903 is low level in the normal operational state of the IGBT 330, since the sense voltage Vs is lower than the overcurrent detection level Vs1. In contrast, the output of the overcurrent detection comparator 903 change from low level to high level, when the IGBT 330 becomes in overcurrent state, since the sense voltage Vs becomes higher than the overcurrent detection level Vs1. According to this arrangement, the overcurrent signal is output from the overcurrent detection unit 802 by the output from the overcurrent detection comparator 903 changing from low level to high level. When the output of the overcurrent detection comparator 903 goes to high level, the drive interruption unit 804 determines that there is an abnormality overcurrent state, and outputs a latch signal to the drive unit 805 as an abnormality interrupting signal.

It should be understood that sometimes it may be the case that the output of the overcurrent detection comparator 903 fluctuates, since the sense voltage Vs is subject to the switching noise of the IGBTs 330. This type of fluctuation of the output of the overcurrent detection comparator 903 is associated with erroneous detection of overcurrent. Because of this, the output fluctuation of the overcurrent detection comparator 903 due to noise is suppressed by cutting out, as being noise components, voltage signals of a predetermined frequency and higher that are output from the overcurrent detection comparator 903. The filter time constant of the noise filter 803 is smaller than the time constant of a filter (not shown in the figures) that is used during normal operation.

And the short-circuit detection unit 806 is constituted by a comparator 905 for short-circuit detection. The gate voltage Vg is input to one side of this short-circuit detection comparator 905, for example to its non-inverting input side. Moreover, a reference voltage that is equivalent to the predetermined short-circuit detection level Vg2 is input to its other input side, for example to its inverting input side. It should be understood that the short-circuit detection level Vg2 is higher than the gate power supply voltage. The output of the short circuit detection comparator 905 is low level in the normal operational state of the IGBT 330, since the gate voltage Vg is lower than the short-circuit detection level Vg2. On the other hand, when the IGBT 330 goes into the short-circuit state, the output of the short circuit detection comparator 905 goes to high level, since the gate voltage Vg becomes higher than the short-circuit detection level Vg2. According to this arrangement, a short-circuit detection signal is output from the short-circuit detection unit 806 by the output from the overcurrent detection comparator 905 changing from low level to high level. When the output of the short-circuit detection comparator 905 goes to high level, the drive interruption unit 804 determines that there is an abnormality short-circuit state, and outputs a latch signal to the drive unit 805 as an abnormality interrupting signal.

It should be understood that the circuit structures for the overcurrent detection unit 802 and for the short-circuit detection unit 806 explained above are only given by way of example, and their details should not be considered as being limitative. It would also be acceptable to arrange to provide different circuit structures for implementing the same functions.

Fig. 5 is a time chart during the operation of the semiconductor element control device explained above. Examples of the waveforms during normal operation, during overcurrent, and during short-circuit are all shown in this time chart.

In Fig. 5, the reference symbol 1001 indicates an example of the waveform gate voltage of the IGBT 330, the reference symbol 1002 indicates an example of the waveform of the collector voltage of the IGBT 330 (i.e. of the voltage between the collector and the emitter), and the reference symbol 1003 indicates an example of the waveform of the collector current. Moreover, the reference symbol 1004 indicates an example of the short-circuit detection level Vg2 for the gate voltage 1001, while the reference symbol 1006 indicates the overcurrent detection level Ic1 for the collector current 1003. It should be understood that the short-circuit detection level Vg2 is higher than the gate power supply voltage. While, in Fig. 5, the overcurrent detection level Ic1 is set to twice the rated current Ic of the IGBT 330, this is not limitative of the overcurrent detection level that can be set. In each of the waveforms shown by the reference symbols 1008 through 1010, the reference symbol 1008 indicates a waveform during a normal operation, the reference symbol 1009 indicates a waveform during an overcurrent abnormality, and the reference symbol 1010 indicates a waveform during a short-circuit abnormality.

As shown in Fig. 5, during the normal operational state 1008, the collector current 1003 is lower than the overcurrent detection level Ic1 shown by the reference symbol 1006, and moreover the gate voltage 1001 is lower than the short-circuit detection level Vg2 shown by the reference symbol 1004. Accordingly, neither overcurrent nor short-circuit is detected.

On the other hand it will be understood that, during the overcurrent abnormality 1009, the collector current 1003 exceeds the overcurrent detection level Ic1. At this time, by setting the previously described overcurrent level Vs1 in advance to correspond to the overcurrent detection level Ic1, an overcurrent state is detected by the overcurrent detection unit 802, and an overcurrent detection signal is output from the overcurrent detection unit 802. As a result, the gate voltage 1001 is interrupted in software by the drive unit 805.

Furthermore it will be understood that, during the short-circuit abnormality 1010, after the collector voltage 1002 has instantaneously dropped in correspondence to the start of the flow of short-circuit current in the IGBT 330, it returns to the neighborhood of the power supply voltage. At this time, as previously described and as shown by the reference symbol 1011, the gate voltage 1001 spikes up to greater than or equal to the power supply voltage, due to a current corresponding to the change over time of the collector voltage 1002 and corresponding to the feedback capacitance of the IGBT 330 flowing to the gate of the IGBT 330. And when, due to this spike phenomenon, the gate voltage 1001 exceeds the short-circuit detection level Vg2 shown by the reference symbol 1004, then a short-circuit state is detected by the short-circuit detection unit 806, and a short-circuit detection signal is output from the short-circuit detection unit 806. As a result, short-circuit protection operation for the IGBT 330 is performed by the drive unit 805.

When detecting overcurrent and short-circuit on the basis of a sense current as in the prior art, it is necessary to set the short-circuit detection level to be greater than the overcurrent detection level, in consideration of fluctuations of the sense current. Due to this, it is not possible to perform protection against short-circuit in a manner appropriate for incomplete short-circuit, such as when the short circuit current stops at an intermediate level between the overcurrent detection level and the short-circuit detection level. On the other hand since, with the present invention, as explained in the above description, the phenomenon that the gate voltage exhibits a spiking up characteristic during short-circuit is taken advantage of in order to detect the short-circuit, accordingly it is possible to detect incomplete short-circuit as well. Therefore the possibilities of erroneous detection of short-circuit or of failure of short-circuit protection due to fluctuation of the sense current are eliminated, so that it is possible to implement highly reliable short-circuit protection.

According to this embodiment as explained above, the following beneficial operational effects are obtained.

(1) The short-circuit detection unit 806 detects short-circuit of the IGBT 330 on the basis of the gate terminal voltage of the IGBT 330, and outputs a short-circuit detection signal if short-circuit has been detected. And, on the basis of the short-circuit detection signal output from the short-circuit detection unit 806, the drive interruption unit 804 interrupts the flow of current to the IGBT 330 by outputting an abnormality interrupting signal to the drive unit 805. Since, due to this, it is arranged to take advantage of the phenomenon that the gate voltage exhibits a spiking up characteristic during short-circuit in order to detect the short-circuit, accordingly there is no possibility of erroneous detection of short-circuit even if the sense current carries switching noise or the like, so that it is possible to implement highly reliable short-circuit protection.

(2) The overcurrent detection unit 802 detects the flowing of overcurrent in the IGBT 330 on the basis of the sense current output by the IGBT 330, and outputs an overcurrent detection signal if overcurrent has been detected. And, along with interrupting the flow of current to the IGBT 330 on the basis of the short-circuit detection signal output from the short-circuit detection unit 806 as described above, the drive interruption unit 804 also interrupts the flow of current to the IGBT 330 by outputting an abnormality interrupting signal to the drive unit 805 on the basis of the overcurrent detection signal from which the noise component has been eliminated by the noise filter 803. Due to these arrangements, in addition to the possibility of short-circuit being eliminated, it is also possible to eliminate erroneous detection of overcurrent, so that it is possible to implement highly reliable short-circuit protection.

### - Second Embodiment -

Next, a second embodiment of the present invention will be explained. In this embodiment, a different semiconductor element control device is used from the one explained above for the first embodiment. It should be understood that since, for this embodiment, the circuit structure of the control blocks and the in-vehicle control system of the hybrid automobile are the same as those for the first embodiment as shown in Figs. 1 and 2, accordingly explanation thereof will be omitted.

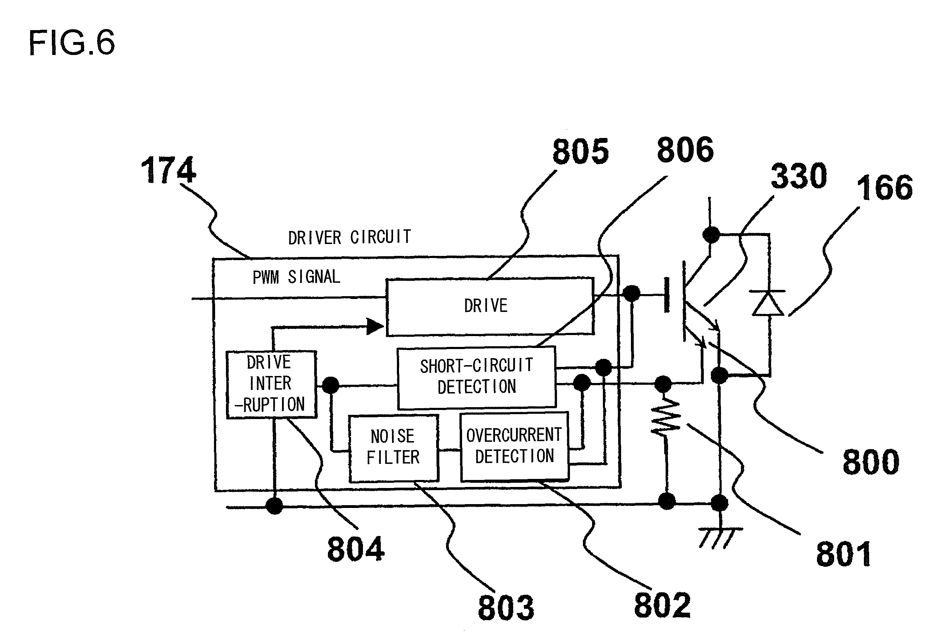

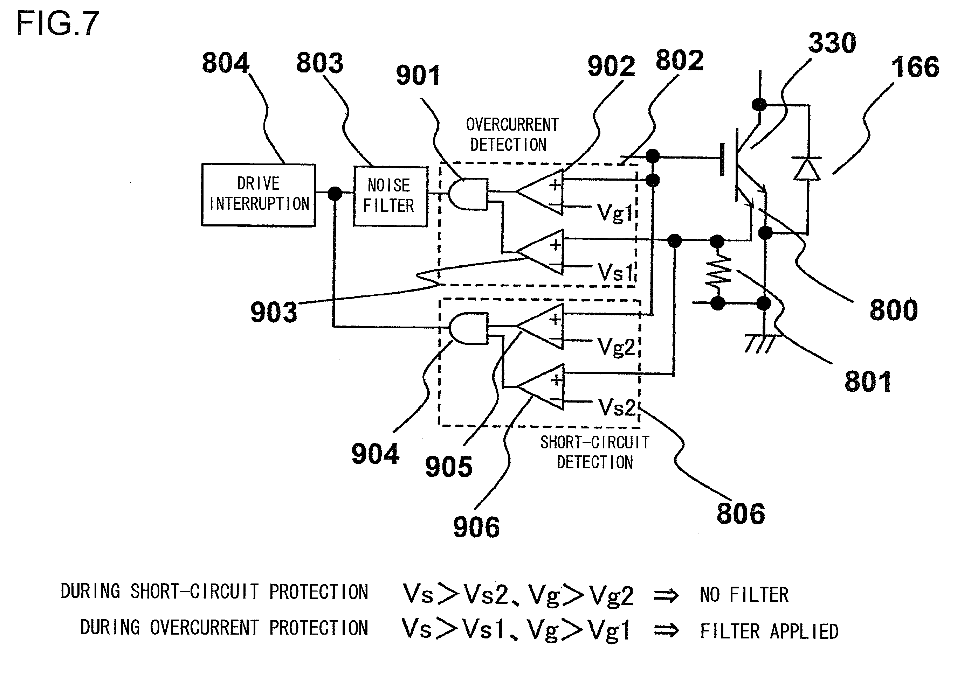

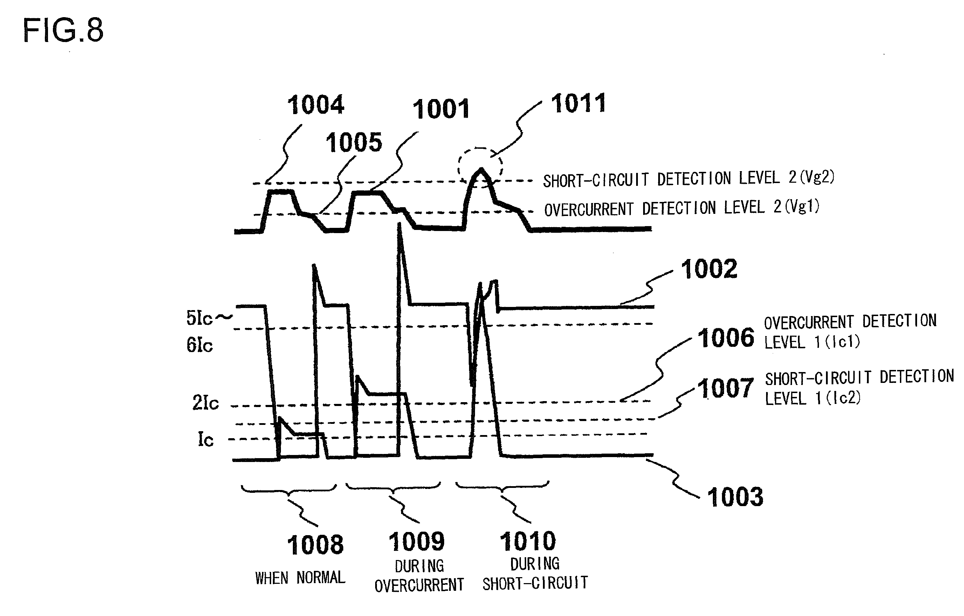

Fig. 6 is a circuit block diagram of a semiconductor element control device related to this embodiment, Fig. 7 is a circuit diagram of this semiconductor element control device related to this embodiment, and Fig. 8 is a time chart for this semiconductor element control device related to this embodiment during operation. It should be understood that in Figs. 6 through 8, to portions that are the same as or that correspond to ones for the first embodiment, the same reference numerals as in Figs. 3 through 5 are appended.

The portions where Fig. 6 is different from Fig. 3 are the feature that the sense voltage generated by the sense current from the sense IGBT 800 is input to the overcurrent detection unit 802 and also to the short-circuit detection unit 806, and the feature that the gate voltage of the IGBT 330 is input to the overcurrent detection unit 802 and also to the short-circuit detection unit 806. Since the other aspects are the same as in Fig. 3, explanation thereof will be omitted in the following description, unless required.

The overcurrent detection unit 802 performs detection of overcurrent flowing in the IGBT 330 on the basis of the result of comparison between the sense voltage that is input and a reference voltage that is set according to a predetermined overcurrent detection level, and on the basis of the result of comparison between the gate voltage that is input and a reference voltage that is set according to a predetermined overcurrent detection level. In other words, overcurrent is detected when the sense voltage Vs is above a predetermined overcurrent detection level Vs1, and moreover the gate voltage Vg is above a predetermined overcurrent detection level Vg1. It should be understood that the overcurrent detection level Vg1 for the gate voltage Vs is a voltage that is higher than the threshold voltage for turning the IGBT 330 on. Moreover, the overcurrent detection level Vs1 for the sense voltage Vs is a voltage that, for example, may correspond to around twice the rated current of the IGBT 330. If overcurrent has been detected, then, in a similar manner to the case with Fig. 3, the overcurrent detection unit 802 outputs an overcurrent detection signal to a drive interruption unit 804 via a noise filter 803.

The short-circuit detection unit 806 performs detection of short-circuit of the IGBT 330 on the basis of the result of comparison between the sense voltage that is input and a reference voltage that is set according to a predetermined short-circuit detection level, and on the basis of the result of comparison between the gate voltage that is input and a reference voltage that is set according to a predetermined short-circuit detection level. In other words, short-circuit is detected when the sense voltage Vs is above a predetermined short-circuit detection level Vs2, and moreover the gate voltage Vg is above a predetermined short-circuit detection level Vg2. It should be understood that it is desirable for the short-circuit detection level Vg2 for the gate voltage Vs to be a voltage that is higher than the above described overcurrent detection level Vg1. On the other hand, it is desirable for the short-circuit detection level Vs2 for the sense voltage Vs to be a voltage that is less than or equal to the above described overcurrent detection level Vs1. With these arrangements, while on the one hand preventing erroneous detection of short-circuit, even if short-circuit takes place of a type in which the short-circuit current stops between the overcurrent detection level Vs1 and the short-circuit detection level Vs2, still it is possible to detect this with the short-circuit detection unit 806. If short-circuit has been detected, then, in a similar manner to the case with Fig. 3, the short-circuit detection unit 806 outputs a short-circuit detection signal to the drive interruption unit 804.

Fig. 7 shows an example of a circuit that implements the functions of the overcurrent detection unit 802 and of the short-circuit detection unit 806 according to this embodiment. The overcurrent detection unit 802 is constituted by an AND circuit 901 for overcurrent detection and by comparators 902 and 903 for overcurrent detection. It should be understood that the overcurrent detection comparator 903 is the same as in the case of the first embodiment shown in Fig. 4.

The gate voltage Vg is input to one of the input sides of the overcurrent detection comparator 902, for example to its non-inverting input side. Moreover, a reference voltage that corresponds to the overcurrent detection level Vg1 is input to its other input side, for example to its inverting input side. And, in a similar manner to the case with Fig. 4, the sense voltage Vs of the sense resistor 801 is input to one of the input sides of the overcurrent detection comparator 903, for example to its non-inverting input side. Moreover, a reference voltage that corresponds to the overcurrent detection level Vs1 is input to its other input side, for example to its inverting input side. And the AND circuit for overcurrent detection 901 calculates the AND of the outputs of the overcurrent detection comparators 902 and 903, and outputs this result to the drive interruption unit 804 via the noise filter 803.

In the normal operational state of the IGBT 330, the output of the overcurrent detection comparator 903 is low level, since the sense voltage Vs is lower than the overcurrent detection level Vs1. Due to this, the output of the AND circuit for overcurrent detection 901 is low level, irrespective of the output of the overcurrent detection comparator 902. On the other hand, when the IGBT 330 goes into an overcurrent state, the output of the overcurrent detection comparator 903 becomes high level, since the sense voltage Vs now comes to be higher than the overcurrent detection level Vs1. Furthermore, since the gate voltage Vg is higher than the overcurrent detection level Vg1, accordingly the output of the overcurrent detection comparator 902 is also high level. Thus, the output of the AND circuit for overcurrent detection 901 goes to high level. With these arrangements, and due to the output from the AND circuit for overcurrent detection 901 changing from low level to high level, a latch signal is output from the overcurrent detection unit 802 as an overcurrent detection signal (i.e. as an abnormality interrupting signal).

It should be understood that the noise component in the output from the AND circuit for overcurrent detection 901 is cut down by the noise filter 803. Due to this, fluctuations of the output of the AND circuit for overcurrent detection 901 that originate when the output of the overcurrent detection comparator 903 fluctuates due to switching noise from the IGBT 330 carried upon the sense voltage Vs are suppressed.

The short-circuit detection unit 806 includes an AND circuit 904 for short-circuit detection and comparators 905 and 906 for short-circuit detection. It should be understood that the short-circuit detection comparator 905 is the same as the one in the first embodiment shown in Fig. 4.

In a similar manner to the case in Fig. 4, the gate voltage Vg is input to one of the input sides of the short-circuit detection comparator 905, for example to its non-inverting input side. Moreover, a reference voltage that corresponds to the short-circuit detection level Vg2 is input to its other input side, for example to its inverting input side. And the sense voltage Vs of the sense resistor 801 is input to one of the input sides of the short-circuit detection comparator 906, for example to its non-inverting input side. Moreover, a reference voltage that corresponds to the short-circuit detection level Vs2 is input to its other input side, for example to its inverting input side. And the AND circuit for short-circuit detection 904 calculates the AND of the outputs of the short-circuit detection comparators 905 and 906, and outputs this result to the drive interruption unit 804.

In the normal operational state of the IGBT 330, the output of the short-circuit detection comparator 905 is low level, since the gate voltage Vg is lower than the short-circuit detection level Vg2. Due to this, the output of the AND circuit for short-circuit detection 904 is low level, irrespective of the output of the short-circuit detection comparator 906. On the other hand, when the IGBT 330 goes into a short-circuit state, the output of the short-circuit detection comparator 905 becomes high level, since the gate voltage Vg now comes to be higher than the short-circuit detection level Vg2. Furthermore, since the sense voltage Vs is higher than the short-circuit detection level Vs2, accordingly the output of the short-circuit detection comparator 906 is also high level. Thus, the output of the AND circuit for short-circuit detection 904 goes to high level. With these arrangements, and due to the output from the AND circuit for short-circuit detection 904 changing from low level to high level, a latch signal is output from the short-circuit detection unit 806 as a short-circuit detection signal (i.e. as an abnormality interrupting signal).

It should be understood that the circuit structures for the overcurrent detection unit 802 and for the short-circuit detection unit 806 explained above are only given by way of example, and their details should not be considered as being limitative. It would also be acceptable to arrange to provide different circuit structures for implementing the same functions.

Fig. 8 is a time chart during the operation of the semiconductor element control device explained above. Examples of the waveforms during normal operation, during overcurrent, and during short-circuit are all shown in this time chart, just as shown in Fig. 5 for the first embodiment.

In Fig. 8, the reference symbol 1005 denotes the overcurrent detection level Vg1 for the gate voltage 1001, while the reference symbol 1007 denotes the short-circuit detection level Ic2 for the collector current 1003. It should be understood that the overcurrent detection level Vg1 is higher than the gate power supply voltage, and is similarly lower than the short-circuit detection level Vg2. Moreover, the short-circuit detection level Ic2 is similarly lower than the overcurrent detection level Ic 1.

As shown in Fig. 8, during the normal operational state 1008, the collector current 1003 is lower than the overcurrent detection level Ic1 shown by the reference symbol 1006, and moreover the gate voltage 1001 is lower than the short-circuit detection level Vg2 shown by the reference symbol 1004. Accordingly, neither overcurrent nor short-circuit is detected. It should be understood that even if, during the normal operational state 1008, the collector current 1003 exceeds the short-circuit detection level Ic2 denoted by the reference symbol 1007, still the short circuited state is not detected by the short-circuit detection unit 806, since the gate voltage 1001 does not exceed the short-circuit detection level Vg2 denoted by the reference symbol 1004.

On the other hand it will be understood that, during the abnormality overcurrent state 1009, the collector current 1003 exceeds the overcurrent detection level Ic1, and moreover the gate voltage 1001 exceeds the overcurrent detection level Vg1 denoted by the reference symbol 1005. At this time, by setting the previously described overcurrent level Vs1 in advance so as to correspond to the overcurrent detection level Ic1, an overcurrent state is detected by the overcurrent detection unit 802, and an overcurrent detection signal is output from the overcurrent detection unit 802. As a result, the gate voltage 1001 is interrupted in software by the drive unit 805.

Furthermore, during the abnormality short-circuit state 1010, due to the spiking up phenomenon as shown by the reference symbol 1011, the gate voltage 1001 exceeds the short-circuit detection level Vg2 shown by the reference symbol 1004, and moreover the collector current 1003 exceeds the short-circuit detection level Ic2 shown by the reference symbol 1007. At this time, due to the short-circuit detection level Vs2 being set in advance to correspond to the short-circuit detection level Ic2 as previously described, a short circuited state is detected by the short-circuit detection unit 806, and a short-circuit detection signal is output from the short-circuit detection unit 806. As a result, short-circuit protection operation for the IGBT 330 is performed by the drive unit 805.

According to this embodiment as explained above, the following beneficial operational effects are obtained.

(1) The short-circuit detection unit 806 detects short-circuit of the IGBT 330 on the basis of the gate terminal voltage of the IGBT 330 and the sense current output by the IGBT 330, and outputs a short-circuit detection signal if short-circuit has been detected. Moreover, the overcurrent detection unit 802 detects overcurrent flowing in the IGBT 330 on the basis of the gate terminal voltage of the IGBT 330 and the sense current output by the IGBT 330, and outputs an overcurrent detection signal if overcurrent has been detected. Since this is done, it is possible to perform short-circuit detection and overcurrent detection with even higher reliability, as compared with the first embodiment.

(2) The overcurrent detection unit 802 detects that overcurrent is flowing in the IGBT 330 and outputs an overcurrent detection signal, when the gate terminal voltage of the IGBT 330 exceeds the predetermined overcurrent detection level Vg1 and moreover the sense current output by the IGBT 330 has exceeded the predetermined overcurrent detection level Ic1. Moreover, the short-circuit detection unit 806 detects short-circuit of the IGBT 330 and outputs a short-circuit detection signal, when the gate terminal voltage of the IGBT 330 exceeds the predetermined short-circuit detection level Vg2 that is greater than or equal to the overcurrent detection level Vg1 and moreover the sense current output by the IGBT 330 has exceeded the predetermined short-circuit detection level Ic2 that is less than or equal to the overcurrent detection level Ic1. With these arrangements, on the one hand erroneous detection of short-circuit by the short-circuit detection unit 806 is prevented, and also, even if short-circuit occurs in such a manner that the short-circuit current stops between the overcurrent detection level and the short-circuit detection level, still it is possible for this to be detected by the short-circuit detection unit 806.

### - Variant Embodiment #1 -

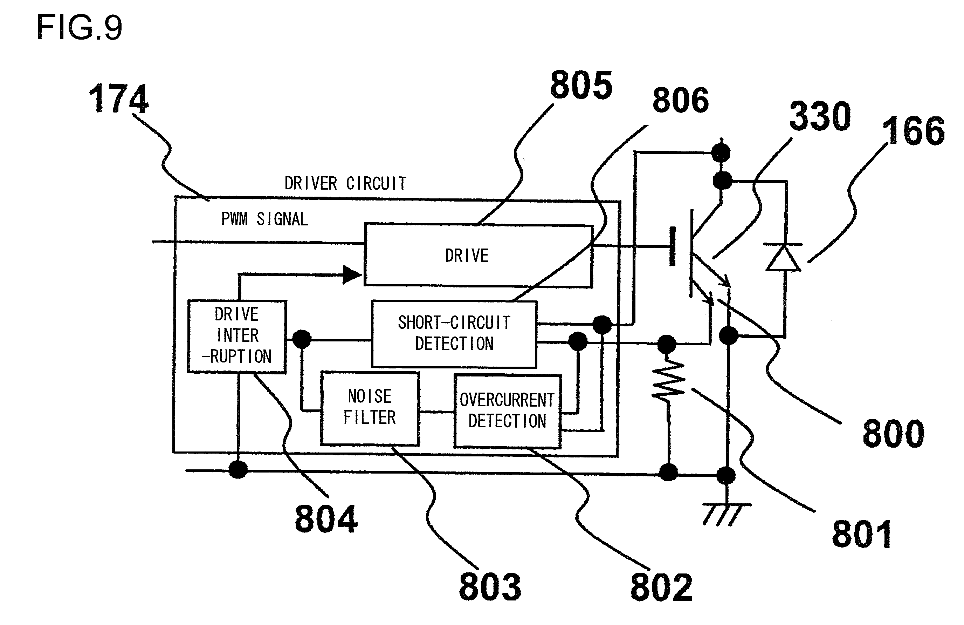

The circuit block diagram of Fig. 9 shows a variant of the second embodiment described above. The aspect by which the circuit shown in Fig. 6 and the circuit shown in Fig. 9 are different is the feature that, by contrast to the case in Fig. 6 in which short-circuit detection and overcurrent detection were performed on the basis of the gate voltage and the sense voltage, in the case of Fig. 9 short-circuit detection and overcurrent detection are performed on the basis of the collector voltage and the sense voltage. Similar beneficial effects to those explained in connection with the second embodiment are obtained using this circuit as well.

### - Variant Embodiment #2 -

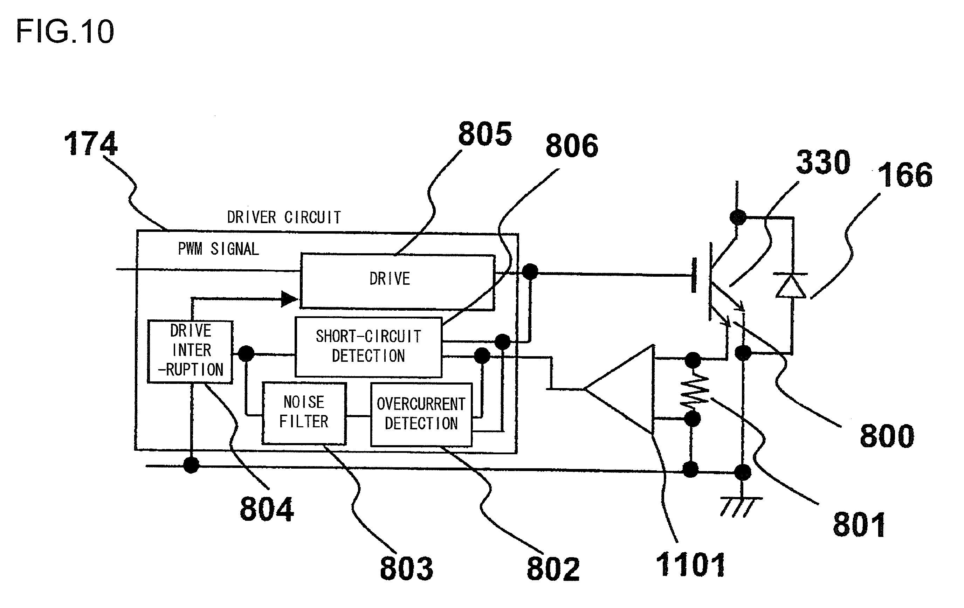

The circuit block diagram of Fig. 10 shows another variant of the second embodiment described above. The aspect by which the circuit shown in Fig. 6 and the circuit shown in Fig. 10 are different is the feature that, by contrast to the case shown in Fig. 6 in which the sense voltage is directly input to the short-circuit detection circuit 806 and to the overcurrent detection circuit 802, in the case of Fig. 10 the sense voltage between the two ends of the sense resistor 801 is detected via a differential amp 1101. Due to this, along with it being possible to alleviate the parasitic inductance of the wiring from the sense resistor 801 both to the short-circuit detection circuit 806 and to the overcurrent detection circuit 802, it is also possible to reduce errors in the detection of the sense voltage that originate in switching noise of the IGBT 330. Similar beneficial effects to those explained in connection with the second embodiment are obtained using this circuit as well.

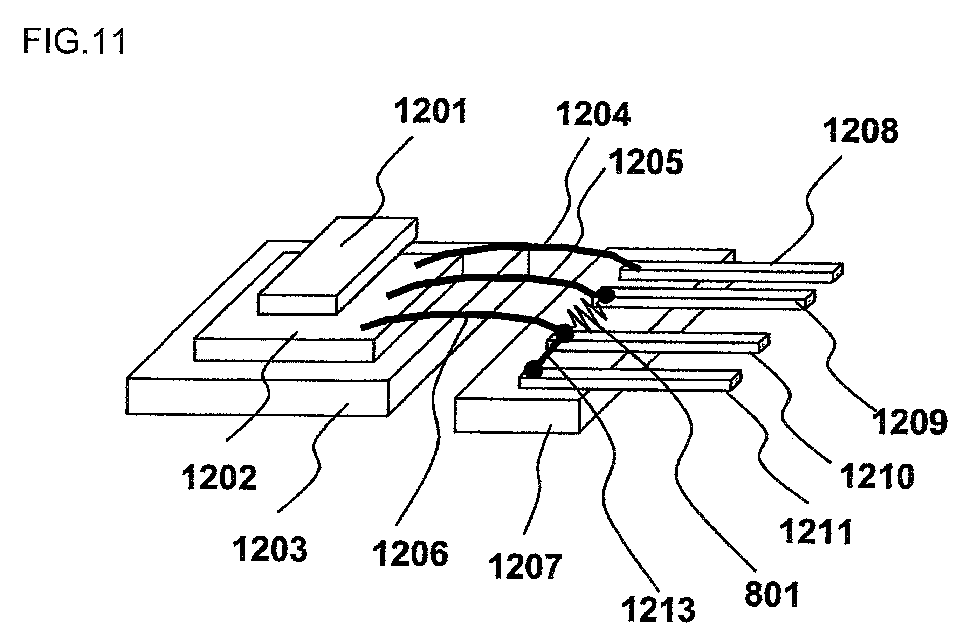

Fig. 11 shows an example of the arrangement of the sense resistor in the circuit shown in Fig. 10. In Fig. 11, the reference symbol 1201 denotes a lead electrode for the emitter of the IGBT 330, the reference symbol 1202 denotes a chip that contains the IGBT 330 and the sense IGBT 800, and the reference symbol 1203 denotes the collector electrode of the IGBT 330. The IGBT 330 is connected to the gate electrode terminal 1208 and to a negative sense terminal 1210 with wirings 1204 and 1206 respectively by wire bonding. And the sense IGBT 800 is connected to a positive sense terminal 1209 with wiring 1205 by wire bonding. The negative sense terminal 1210 is connected to the emitter electrode terminal 1211 by wiring 1213. The gate electrode terminal 1208, the positive sense terminal 1209, the negative sense terminal 1210, and the emitter electrode terminal 1211 are provided upon a control electrode terminal base 1207. And the sense resistor 801 is disposed between the positive sense terminal 1209 and the negative sense terminal 1210.

In Fig. 11, the negative sense terminal 1201 and the emitter electrode terminal 1211 are arranged separately. Moreover, the sense resistor 801 is implemented close to the chip 1202. Due to these features, it is possible to keep the parasitic inductance described previously as small as possible.

It should be understood that the various embodiments and variant embodiments explained above may also be combined in various ways. And the variant embodiments may also be combined in any desired manner.

While, in the various embodiments and variant embodiments explained above, examples of semiconductor element control devices provided with both an overcurrent detection unit 802 and a short-circuit detection unit 806 have been described, it would also be acceptable to arrange to provide only one or the other of these elements. In other words, the present invention could also be applied to a semiconductor element control device that performs one or the other of overcurrent detection and short-circuit detection using a method as described above, and that executes protective operation for the circuitry according to the result of that detection.

The above explanation is only an example; the present invention is not to be considered as being limited by the structure of the embodiments described above.

### EXPLANATION OF THE REFERENCE SYMBOLS

43: inverter device for auxiliary machinery
110: hybrid electric automobile
112: front wheel
114: front wheel axle
116: front wheel side DG
118: transmission
120: engine
121: engine system
122: power distribution mechanism
123, 124, 125, 126, 127, 128, 129, 130: gear wheels
131: engine control unit
132: fuel tank
136: battery
138: DC connector
140, 142: inverter devices
144: inverter circuit
150: series circuit of upper and lower arm
153: collector electrode of upper arm
154: gate electrode terminal of upper arm
155: signal emitter electrode terminal of upper arm
156: diode of upper arm
157: positive (P) terminal
158: negative (N) terminal
159: AC terminal
163: collector electrode of lower arm
164: gate electrode terminal of lower arm
165: signal emitter electrode terminal of lower arm
166: diode of lower arm
169: intermediate electrode
170: control unit
172: control circuit
174: driver circuit
176, 182: signal lines
180: current detection unit
186: AC power line
188: AC connector
192, 194: motor-generators
195: motor for auxiliary machinery
200: power conversion device
250: in-vehicle electrical system
314: DC positive terminal
316: DC negative terminal
328, 330: IGBT500: capacitor module
504: negative side capacitor terminal
506: positive side capacitor terminal
800: sense IGBT
801: sense resistor
802: overcurrent detection unit
803: noise filter
804: drive interruption unit
805: drive unit
806: short-circuit detection unit
901: AND circuit for overcurrent detection
902, 903: overcurrent detection comparator
904: AND circuit for short-circuit detection
905, 906: short-circuit detection comparator
1001: gate voltage waveform
1002: collector voltage waveform
1003: collector current waveform
1004: short-circuit detection level Vg2
1005: overcurrent detection level Vg1
1006: overcurrent detection level Ic1
1007: short-circuit detection level Ic2
1008: normal operational state
1009: abnormality overcurrent state
1010: abnormality short-circuit state
1011: spike phenomenon
1101: differential amp
1201: lead electrode for emitter
1202: chip
1203: collector electrode
1204, 1205, 1206: wiring
1207: control electrode terminal base
1208: gate electrode terminal
1209: positive sense terminal
1210: negative sense terminal
1211: emitter electrode terminal

## Claims

1. A semiconductor element control device that controls a semiconductor element that performs switching operation for converting DC power into AC power, or AC power into DC power, comprising:
a drive unit that outputs a drive signal for controlling the switching operation of the semiconductor element to a terminal of the semiconductor element;
a short-circuit detection unit that detects short-circuit of the semiconductor element on the basis of the voltage at the terminal, and outputs a short-circuit detection signal;
and a drive interruption unit that interrupts current flowing in the semiconductor element on the basis of the short-circuit detection signal output from the short-circuit detection unit.

2. The semiconductor element control device according to Claim 1, further comprising:
an overcurrent detection unit that detects overcurrent flowing in the semiconductor element on the basis of a sense current output by the semiconductor element, and outputs an overcurrent detection signal; and
a filter unit that eliminates a noise component in the overcurrent detection signal output from the overcurrent detection unit;
wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.

3. A semiconductor element control device that controls a semiconductor element that performs switching operation for converting DC power into AC power, comprising:
a drive unit that outputs a drive signal for controlling the switching operation of the semiconductor element to a terminal of the semiconductor element;
a short-circuit detection unit that detects short-circuit of the semiconductor element on the basis of the voltage at the terminal and a sense current output by the semiconductor element, and outputs a short-circuit detection signal;
and a drive interruption unit that interrupts current flowing in the semiconductor element on the basis of the short-circuit detection signal output from the short-circuit detection unit.

4. The semiconductor element control device according to Claim 3, further comprising:
an overcurrent detection unit that detects overcurrent in the semiconductor element on the basis of the voltage at the terminal and the sense current, and outputs an overcurrent detection signal; and
and a filter unit that eliminates a noise component in the overcurrent detection signal output from the overcurrent detection unit;
wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.

5. The semiconductor element control device according to Claim 4, wherein:
the overcurrent detection unit detects overcurrent in the semiconductor element and outputs the overcurrent detection signal, when the voltage at the terminal exceeds a predetermined first voltage value, and also the sense current exceeds a predetermined first current value; and
the short-circuit detection unit detects short-circuit of the semiconductor element and outputs the short-circuit detection signal, when the voltage at the terminal exceeds a predetermined second voltage value that is higher than or equal to the first voltage value, and also the sense current exceeds a predetermined second current value that is less than or equal to the first current value.

6. An in-vehicle electrical system, comprising:
an in-vehicle power supply that can be charged and discharged;
a motor-generator that generates mechanical power on the basis of AC electrical power, and AC power on the basis of mechanical power; and
a power conversion device that, along with converting DC power from the in-vehicle power supply to AC power that it supplies to the motor-generator, also converts AC power generated by the motor-generator to DC power with which it charges up the in-vehicle power supply;
wherein the power conversion device comprises:
a plurality of semiconductor elements that perform switching operation for converting DC power from the in-vehicle power supply into AC power, or AC power generated by the motor-generator into DC power;
a drive unit that outputs drive signals for controlling the switching operation of the semiconductor element to terminals of the semiconductor element;
a short-circuit detection unit that detects short-circuit of the semiconductor element on the basis of the voltage at the terminal, and outputs a short-circuit detection signal; and
a drive interruption unit that interrupts current flowing in the semiconductor element on the basis of the short-circuit detection signal output from the short-circuit detection unit.

7. The in-vehicle electrical system according to Claim 6, wherein the power conversion device further comprises:
an overcurrent detection unit that detects overcurrent flowing in the semiconductor element on the basis of sense current output by the semiconductor element, and outputs an overcurrent detection signal; and
a filter unit that eliminates a noise component in the overcurrent detection signal output from the overcurrent detection unit;
wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.

8. An in-vehicle electrical system, comprising:
an in-vehicle power supply that can perform charging and discharging;
a motor-generator that generates mechanical power on the basis of AC electrical power, and AC power on the basis of mechanical power;
and a power conversion device that, along with converting DC power from the in-vehicle power supply to AC power that it supplies to the motor-generator, also converts AC power generated by the motor-generator to DC power with which it charges up the in-vehicle power supply;
wherein the power conversion device comprises:
a plurality of semiconductor elements that perform switching operation for converting DC power from the in-vehicle power supply into AC power, or AC power generated by the motor-generator into DC power;
a drive unit that outputs drive signals for controlling the switching operation of the semiconductor element to terminals of the semiconductor element;
a short-circuit detection unit that detects short-circuit of the semiconductor element on the basis of the voltage at the terminal and sense current output by the semiconductor element, and outputs a short-circuit detection signal; and
a drive interruption unit that interrupts current flowing in the semiconductor element on the basis of the short-circuit detection signal output from the short-circuit detection unit.

9. The in-vehicle electrical system according to Claim 8, wherein the power conversion device further comprises
an overcurrent detection unit that detects overcurrent flowing in the semiconductor element on the basis of the voltages at the terminals and the sense current, and outputs an overcurrent detection signal; and
a filter unit that eliminates a noise component in the overcurrent detection signal output from the overcurrent detection unit;
wherein the drive interruption unit, along with interrupting current flowing in the semiconductor element on the basis of the short-circuit detection signal, also interrupts current flowing in the semiconductor element on the basis of the overcurrent detection signal from which the noise component has been eliminated by the filter unit.

10. The in-vehicle electrical system according to Claim 9, wherein:
the overcurrent detection unit detects overcurrent flowing in the semiconductor element and outputs the overcurrent detection signal, when the voltage at the terminal exceeds a predetermined first voltage value, and also the sense current exceeds a predetermined first current value; and
the short circuit detection unit detects short-circuit of the semiconductor element and outputs the short-circuit detection signal, when the voltage at the terminal exceeds a predetermined second voltage value that is less than or equal to the first voltage value, and also the sense current exceeds a predetermined second current value that is less than or equal to the first current value.
